# EUROPÄISCHE PATENTANMELDUNG

(11) **EP 1 098 014 A1**
(43) Veröffentlichungstag der Anmeldung: **09.05.2001**
(21) Anmeldenummer: 00122894.9
(22) Anmeldetag: 20.10.2000
(51) Int. Cl.: C23C 14/06

(54) **Substrate mit einer Chrom-Nitrid-Schicht**

(30) Priorität: 02.11.1999 DE 19952549
(71) Anmelder: HAUZER TECHNO COATING EUROPE BV, 5900 AE Venlo (NL)
(72) Erfinder: Hurkmans, Antonius P.A., 5862 AE Geysteren (NL); Van Der Kolk, Gerrit-Jan, 6062 RG Maarheze (NL); Lewis, David Brian, Sheffield S11 8YA (GB); Münz, Wolf-Dieter, Sheffield S7 1SL (GB)
(74) Vertreter: Manitz, Finsterwald & Partner Gbr

(57) **Zusammenfassung**

Es wird eine mittels eines PVD-Verfahrens auf ein Substrat aufgebrachte Chromnitrid-Schicht mit Härtewerten größer HV2700 beschrieben, wobei diese Chromnitrid-Schicht ein kubisch-flächenzentriertes Kristallgitter mit einer bevorzugten Orientierung in der {200}-Richtung aufweist.

## Beschreibung

Die Erfindung betrifft eine auf ein Substrat aufgebrachte Chrom-Nitrid-Schicht.

Unter den typischen binären Hartstoffschichten mit Härtewerten HV 1500 bis 2300 besitzen herkömmliche Chrom-Nitrid-Schichten die niedrigsten Härtewerte. Diese vergleichsweise niedrigen Härtewerte stellen in vielen Anwendungsfällen einen Nachteil der Chrom-Nitrid-Schichten dar.

Aufgabe der Erfindung ist es, Chrom-Nitrid-Schichten insbesondere hinsichtlich ihrer Härteeigenschaften zu verbessern.

Gelöst wird diese Aufgabe nach der Erfindung im wesentlichen dadurch, daß den Chrom-Nitrid-Schichten insbesondere durch entsprechende Parameterwahl im Herstellungsverfahren ein kubisch-flächenzentriertes Kristallgitter mit einer bevorzugten Orientierung in der {200}-Richtung verliehen wird.

Besonders bevorzugt ist es, eine Chrom-Nitrid-Schicht mit einem kubischflächenzentrierten Kristallgitter mit bevorzugter Orientierung in der {200}-Richtung zu schaffen, das weitere Peaks mit abfallender Intensität in den Ebenen {111}, {311} und {220} aufweist (Bragg-Bretano Cu-Kα).

Die Herstellung der jeweiligen Chrom-Nitrid-Schicht mit kubischflächenzentriertem Kristallgitter dieser Art erfolgt mittels Kathodenzerstäuben, kathodischer Bogenentladungsverdampfung oder mittels Ionenplattierverfahren. In speziell vorteilhafter Weise läßt sich dabei das sogenannte ABS-Verfahren der Anmelderin einsetzen.

Die Peak-Breite FWHM (entspricht der Full Width Half Method) des {200}-Signals 2θ ist bevorzugt größer 2°, und der Gitterparameter der {200}-Linie ist bevorzugt größer 4,2 Å.

Nach bevorzugten Ausgestaltungen der Erfindung weist die erfindungsgemäße Schicht einen Anteil von etwa 0,01 bis 10 at.% an Yttrium, Scandium und/oder Lanthanium auf, wobei der jeweilige Gehalt vorzugsweise im Bereich von 3 bis 5 at.% gelegen ist.

Yttrium, Scandium und Lanthanium können in die Schicht jeweils alleine, in Form von Gemischen oder in Form aufeinanderfolgender Schichten von ggf. unterschiedlicher Zusammensetzung eingebaut sein.

Im Falle des Einbaus von Schichten aus Y, Sc und/oder La wird bevorzugt eine Periodizität des Schichteinbaus von etwa 2 bis 5 nm gewählt.

Besonders wesentliche Merkmale und Merkmalskombinationen der Erfindung ergeben sich aus den Patentansprüchen.

## Patentansprüche

1. Substrat mit einer Chrom-Nitrid-Schicht,
dadurch **gekennzeichnet,**
daß die Chromnitrid-Schicht ein kubisch-flächenzentriertes Kristallgitter mit einer bevorzugten Orientierung in der {200} Richtung aufweist und Härtewerte größer HV2700 besitzt.

2. Substrat nach Anspruch 1,
dadurch **gekennzeichnet,**
daß das kubisch-flächenzentrierte Kristallgitter zumindest einen weiteren Peak in den Ebenen {111), {311} und {220} (Bragg-Bretano Cu-Kα) aufweist.

3. Substrat nach Anspruch 1 oder 2,
dadurch **gekennzeichnet,**
daß das kubisch-flächenzentrierte Kristallgitter mehrere Peaks mit abfallender Intensität in den Ebenen {111}, {311} und {220} aufweist.

4. Substrat nach einem oder mehreren der vorhergehenden Ansprüche,
dadurch **gekennzeichnet,**
daß durch Einstellung von Prozeßparametern bei dem zur Schichtherstellung verwendeten PVD-Verfahren, insbesondere Kathodenzerstäuben, kathodische Bogenentladungsverdampfung oder Ionenplattierung eine Schichthärte im Bereich von etwa HV2700 bis HV3500 vorgebbar ist.

5. Substrat nach einem der vorhergehenden Ansprüche,
dadurch **gekennzeichnet,**
daß die Peak-Breite FWHM (Full Width Half Method) des {200}-Signals 20 größer 2° ist.

6. Substrat nach einem der vorhergehenden Ansprüche,
dadurch **gekennzeichnet,**
daß der Gitterparameter der {200}-Linie größer 4,2 Å ist.

7. Substrat nach einem oder mehreren der vorhergehenden Ansprüche,
dadurch **gekennzeichnet,**
daß die Schicht einen Gehalt von 0,01 bis 10 at.% an Yttrium, Scandium und/oder Lanthanium aufweist.

8. Substrat nach Anspruch 7,
dadurch **gekennzeichnet,**
daß der Gehalt an Yttrium, Scandium und/oder Lanthanium im Bereich von 3 bis 5 at.% gelegen ist.

9. Substrat nach einem der vorhergehenden Ansprüche,
dadurch **gekennzeichnet,**
daß das Yttrium, Scandium und/oder Lanthanium in geschichteter Weise in die Schicht eingebaut ist.

10. Substrat nach Anspruch 9,
dadurch **gekennzeichnet,**
daß die eingebauten Schichten in unterschiedlicher Schichtstärke vorgesehen sind.

11. Substrat nach einem der vorhergehenden Ansprüche,
dadurch **gekennzeichnet,**
daß die yttriumhaltige, scandiumhaltige und/oder lanthaniumhaltige Chrom-Nitrid-Schicht mit einer Periodizität von etwa 2 bis 5 nm auftritt.

12. Substrat nach einem der vorhergehenden Ansprüche,
dadurch **gekennzeichnet,**
daß die mittlere Korngröße in dem CrN, CrYN, CrScN oder CrLaN kleiner 35 nm ist.
